# EUROPÄISCHE PATENTSCHRIFT

(11) **EP 0 682 810 B1**
(45) Veröffentlichungstag und Bekanntmachung des Hinweises auf die Patenterteilung: **29.04.1998**
(21) Anmeldenummer: 94906825.8
(22) Anmeldetag: 01.02.1994
(51) Int. Cl.: H01L 27/15, B41J 2/45

(54) **OPTISCHER ZEICHENGENERATOR FÜR EINEN ELEKTROGRAFISCHEN DRUCKER**
OPTICAL CHARACTER GENERATOR FOR AN ELECTROGRAPHIC PRINTER
GENERATEUR OPTIQUE DE CARACTERES POUR UNE IMPRIMANTE ELECTROGRAPHIQUE

(30) Priorität: 04.02.1993 DE 4303225
(43) Veröffentlichungstag der Anmeldung: 22.11.1995
(73) Patentinhaber: Océ Printing Systems GmbH, 85586 Poing (DE)
(72) Erfinder: SCHOLZ, Christian, Dr., D-82131 Stockdorf (DE); WIEDEMER, Manfred, D-85737 Ismaning (DE)
(74) Vertreter: Schaumburg, Thoenes & Thurn
(86) Internationale Anmeldenummer: DE9400097
(87) Internationale Veröffentlichungsnummer: WO9418704

(56) Entgegenhaltungen:
- EP-A- 0 086 907
- EP-A- 0 180 479
- EP-A- 0 199 852
- US-A- 4 956 684
- PATENT ABSTRACTS OF JAPAN vol. 14, no. 282 (E-942)19. Juni 1990 & JP,A,02 089 379 (KIYOHASHI KAZUO) 29. März 1990
- PATENT ABSTRACTS OF JAPAN vol. 13, no. 287 (M-844)(3635) 30. Juni 1989 & JP,A,01 080 560 (FUJI XEROX CO. LTD.) 27. März 1989
- PATENT ABSTRACTS OF JAPAN vol. 11, no. 41 (E-478)(2488) 6. Februar 1987 & JP,A,61 207 086 (OKI ELECTRIC IND. CO. LTD.) 13. September 1986
- IEEE TRANSACTIONS ON COMPONENTS,HYBRIDS,AND MANUFACTURING TECHNOLOGY Bd. CHMT-8, Nr. 4 , Dezember 1985 , NEW YORK US Seiten 500 - 504 H. TANABE ET AL. 'High-accuracy die-bonding technology for LED array'

## Beschreibung

Die Erfindung betrifft einen optischen Zeichengenerator für einen elektrografischen Drucker gemäß dem Oberbegriff des Patentanspruches 1.

Ein derartiger optischer Zeichengenerator ist aus der EP-A2-0 180 479 bekannt.

LED-Array-Zeichengeneratoren, wie sie z.B. auch in der EP-B1-0 403 476 beschrieben sind, werden in nichtmechanischen Druckern zur punktweisen Entladung elektrostatischer aufgeladener Fotoleiter eingesetzt. Das so erzeugte latente elektrostatische Bild wird mit Hilfe einer Entwicklerstation eingefärbt und in einer Umdruckstation auf den Aufzeichnungsträger umgedruckt. Zur Erzeugung des Ladungsbildes werden LED-Array-Zeichengeneratoren verwendet, die über eine Ansteuerschaltung und eine BUS-Schaltung mit Ansteuersignalen versorgt werden. Sowohl Ansteuerschaltung als auch BUS-Schaltung sind üblicherweise als separate integrierte Schaltkreise ausgebildet. Die IC's werden auf der Basis von einkristalinem Silizium aufgebaut und enthalten eine Vielzahl von Transistoren zur Analog/Digital-Umwandlung (Schalterfunktion) und zur Verstärkung von Strömen (Treiberfunktion), die für die Versorgung der LED-Arrays benötigt werden.

Die LED-Arrays bestehen in der Regel aus 8, 16, 32, 64 oder 128 in einer Reihe hintereinander angeordneten Leuchtdioden (x-Richtung), die ein- oder mehrzeilig auf einzelnen Monolithen integriert sind. Mehrere aneinander gefügte Monolithen bilden den Zeichengenerator. Die Strukturierung der Dioden erfolgt auf der Basis von Gallium-Arsenid. Jede Diode enthält ein Anschluß-Pad, über dessen Anschluß ein Strom geführt und damit die Diode zum Leuchten angeregt wird. Über die Höhe des Stromes sowie über die Zeit wird die Lichtenergie zur Belichtung des Fotoleiters gesteuert. Jede einzelne LED wird dafür mit je einem Verstärkerausgang eines IC's verbunden. Zu diesem Zweck wird jeder IC sehr nahe an die LED-Arrays positioniert, so daß jedem Anschluß-Pad eines LED-Arrays ein Anschluß-Pad eines Verstärkerausganges des IC's gegenüberliegt. Mit Hilfe von Bondautomaten werden nun die Pads miteinander verbunden. Da jeder Zeichengenerator je nach Länge und Diodenabstand bis zu 11.000 Dioden und damit Bondverbindungen benötigt, ist die Trennung in LED-Chip und IC und die damit erforderliche Anwendung einer Verbindungstechnik nicht nur sehr zeitaufwendig, sondern darüber hinaus auch sehr störanfällig. Ein 300dpi-Zeichengenerator besitzt beispielsweise einen Mitte-Mitte-Abstand der Leuchtdioden von 85µm. Die Breite eines Anschluß-Pads kann deshalb nicht größer als 60µm werden, wenn zwischen jedem Pad ein Sicherheitsabstand von 25µm bleiben soll. Die Positioniergenauigkeit jedes Bondautomaten muß deshalb über die Länge des ganzen Zeichengenerators von z.B. 300.000µm bis 500.000µm so hoch sein, daß sowohl zu Beginn des Bondprozesses das erste Anschluß-Pad, als auch noch das letzte Anschluß-Pad nach 3000 bis 6000 Schrittbewegungen in einem sicheren Bondbereich von ca. ± 25µm liegt.

Um die beim Bonden auftretenden Schwierigkeiten zu verringern, werden verschiedene Möglichkeiten genutzt. Die Anschluß-Pads werden in der y-Richtung versetzt angeordnet, so daß sie breiter ausgeführt werden können und damit der Toleranzbereich für das Bonden vergrößert werden kann. Dies erfordert aber einen größeren Flächenbedarf in der Chip-Fläche und verteuert damit die Chips.

Eine andere Möglichkeit, die in der DE-C2-37 04 984 beschrieben ist, besteht darin, die LED-Arrays von zwei Seiten mit IC's anzusteuern. Dies ergibt zwar die Chance zur Verdoppelung der Anschluß-Pad-Breite, vergrößert aber den Flächenbedarf beim LED-Array und erfordert außerdem die doppelte Anzahl an IC's.

Ein weiterer Nachteil derartiger LED-Zeichengeneratoren besteht darin, daß eine Prüfung der Kombination LED-Array's und IC's erst nach der Montage und dem Bondprozeß am fertigen Zeichengenerator möglich ist. Auftretende Fehler können erst im fertig montierten Zeichengenerator festgestellt werden, weswegen die Reparatur durch Auswechseln der IC's schwierig und teuer ist.

Problematisch ist bei allen LED-Zeichengeneratoren die Wärmeabführung im Druckbetrieb und da vor allem die Abführung der in den LED-Chips (Monolithen) entstehenden Wärme auf den Träger. Durch die geringe Flächenanbindung beim LED-Array kommt im allgemeinen nur eine lunkerfreie Lötverbindung in Frage, wodurch eine Ableitung der Wärme in z-Richtung zu den dort gegebenenfalls angebrachten Kühlrippen möglich wird. Eine günstigere, unproblematischere Klebeverbindung, mittels z.B. Silberleitkleber, erfordert eine großflächige Kontaktfläche.

LED-Arrays mit ausreichender Strahlungsleistung können derzeit nur auf Basis von Gallium-Arsenid-Substraten strukturiert werden. Zur Herstellung der Ansteuerschaltungen und der BUS-Schaltungen wiederum wird meist die bekannte Siliziumtechnologie verwendet, die eine hohe Integrationsdichte logischer und analoger Strukturen ermöglicht. Aus diesem Grunde mußten bisher die LED-Chips und die IC's der Ansteuerschaltungen und der BUS-Schaltungen in der beschriebenen Weise separat auf dem Träger des Zeichengenerators angeordnet und miteinander durch Bondtechnik verknüpft werden.

Aus der EP-A1-0 199 852 ist ein optischer Zeichengenerator für einen elektrografischen Drucker bekannt der aus einer monolithisch integrierten Fotodioden-Ansteuerkombination besteht, bei der auf einem Gallium-Arsenid-Substrat sowohl die zugehörigen LED's als auch die Ansteuerschaltung für die LED's integriert sind.

Werden optische Zeichengeneratoren aus einzelne LED-Arrays aufweisenden Monolithen zusammengesetzt, darf an den Begrenzungen der Monolithen die Leuchtpunktfolge mit vorgegebenem Leuchtpunktabstand nicht gestört sein. Dies ist besonders problematisch bei einer mehrzeiligen Anordnung der LEDs. Um diese Leuchtpunktfolge zu gewährleisten ist es aus der bereits diskutierten EP-B1-0 403 476 bekannt die einzelnen Monolithen durch einen schrägen Schnitt zu trennen und die Monolithen unter Beachtung der Leuchtpunktfolge mit einer Stoßfuge aneinander zu fügen.

Dies erfordert einen hohen Justieraufwand bei der Montage, verursacht weiterhin Materialverluste beim Herausschneiden der Monolithe aus dem Wafer und verringert die Integrationsdichte der LED's.

Aufgabe der Erfindung ist es, einen einfach und verlustarm herzustellenden optischen Zeichengenerator für elektrografische Drucker mit einer hohen Integrationsdichte bereitzustellen, der aus einzelne LED-Arrays tragenden Monolithen zusammengesetzt ist und bei dem im Randbereich der Monolithe die Leuchtpunktfolge sicher gewährleistet wird.

Diese Aufgabe wird bei einem optischen Zeichengenerator der eingangs genannten Art gemäß den Merkmalen des Patentanspruches 1 gelöst.

Vorteilhafte Ausführungsformen sind in den Unteransprüchen gekennzeichnet.

Dadurch, daß im Bereich eines den Rand der Monolithen übergreifenden Lichtpunktes des Zeichengenerators auf den benachbarten Monolithen Teil-Lichtaustrittsöffnungen derart ausgebildet sind, daß die Teil-Lichtaustrittsöffnungen einen gemeinsamen Lichtpunkt bilden, können die Monolithen ohne Stoßfuge und damit ohne Materialverlust aneinander gefügt werden. Der Montageaufwand ist gering. Die Leuchtpunktfolge ist auch im Randbereich der Monolithen gewährleistet.

Bei einer vorteilhaften Ausführungsform bestehen die Monolithen aus einer monolithisch integrierten Fotodiode-Ansteuerkombination, die aus III-V Halbleitermaterial, vorzugsweise Gallium-Arsenid aufgebaut ist, bei der in einem Monolith sowohl die zugehörigen LED's als auch die Ansteuerschaltung für die LED's integriert sind. Damit wird eine hohe Integrationsdichte möglich.

Ein Monolith in Form eines Chips, der aus einem Substrat ausgeschnitten wird, enthält dabei sowohl die Leuchtdioden als auch deren zugehörige Ansteuerschaltung einschließlich der BUS-Schaltung zur Zuführung der Ansteuerdaten.

Ein derartiger Chip kann in Dünnschichttechnik Schicht für Schicht auf einem Gallium-Arsenid-Substrat aufgebaut werden mit dem Abschluß der die Lichtpunkte des Zeichengenerators definierenden Leuchtfenster entsprechend der gewünschten Konfiguration. Dieser Aufbau im Anschluß an die Strukturierung der Ansteuerschaltung bietet die vielfältigsten Variationsmöglichkeiten in der Anordnung der Leuchtfenster. Eine Prüfung jedes derartigen integriert aufgebauten Monolithen kann stets vor dem Zusammenbau des Zeichengenerators erfolgen und reduziert dadurch die Kosten für den bisher üblichen Mehraufwand durch aufwendige notwendige Reparaturen in der Endprüfung.

Die hohe Integrationsdichte der Monolithen ermöglicht außerdem die Verwendung von wärmeleitenden Klebeverbindungen bei der Montage, was eine gute Wärmeableitung im Druckbetrieb gewährleistet. Dies verlängert die Lebensdauer der Zeichengeneratoren und ermöglicht im übrigen eine reduzierte Baugröße mit erhöhter Baugenauigkeit.

Ausführungsformen der Erfindung sind in den Zeichnungen dargestellt und werden im folgenden beispielsweise näher beschrieben. Es zeigen
Figur 1 eine schematische Darstellung einer Draufsicht eines LED-Zeichengenerators, der aus einzelnen Monolithen mit darin integrierter Ansteuerschaltung für die LED's aufgebaut ist, wobei die LED's einzeilig angeordnet sind. Die Monolithen sind mit einer separaten BUS-Ansteuerschaltung gekoppelt;
Figur 2 eine schematische Darstellung einer Draufsicht eines LED-Zeichengenerators gemäß Figur 1, bei der die LED's zweizeilig angeordnet sind;
Figur 3 eine schematische Darstellung einer Draufsicht eines LED-Zeichengenerators mit symmetrischem Aufbau der einzelnen Monolithen bezogen auf eine mittig angeordnete einzeilige LED-Leiste, sowie beidseitig der Monolithen angeordneten BUS-Ansteueranordnungen;
Figur 4 eine schematische Darstellung einer Draufsicht eines LED-Zeichengenerators entsprechend der Figur 3, bei der die LED's versetzt zueinander zweizeilig angeordnet sind;
Figur 5 eine schematische Darstellung einer Draufsicht eines LED-Zeichengenerators aus einzelnen Monolithen mit darin integrierter Ansteuer- und BUS-Schaltung für die LED's, wobei die LED's einzeilig angeordnet sind;
Figur 6 eine schematische Darstellung einer Draufsicht eines LED-Zeichengenerators aus einzelnen symmetrisch aufgebauten Monolithen mit darin integrierter Ansteuer- und BUS-Schaltung, wobei die LED's zweizeilig versetzt zueinander angeordnet sind;
Figur 7 eine schematische Darstellung einer Draufsicht eines einzelnen Monolith mit integrierter Ansteuerschaltung für die LED, die mehrzeilig versetzt zueinander angeordnet sind und
Figur 8 eine vergrößerte Ausschnittsdarstellung der Anordnung der LED's gemäß Figur 7 an der Trennlinie zwischen zwei benachbarten Monolithen.

Ein in den Figuren dargestellter optischer Zeichengenerator für einen elektrografischen Drucker enthält eine Vielzahl von nebeneinander auf einem Träger 10 angeordnete Monolithen 11, die als integrierte Schaltkreise ausgebildet sind und die je nach Ausführungsform ein- oder mehrzeilig angeordnete LED's 12 und die zugehörige Ansteuer- und BUS-Schaltung 13, 14 für die LED's 12 aufweisen.

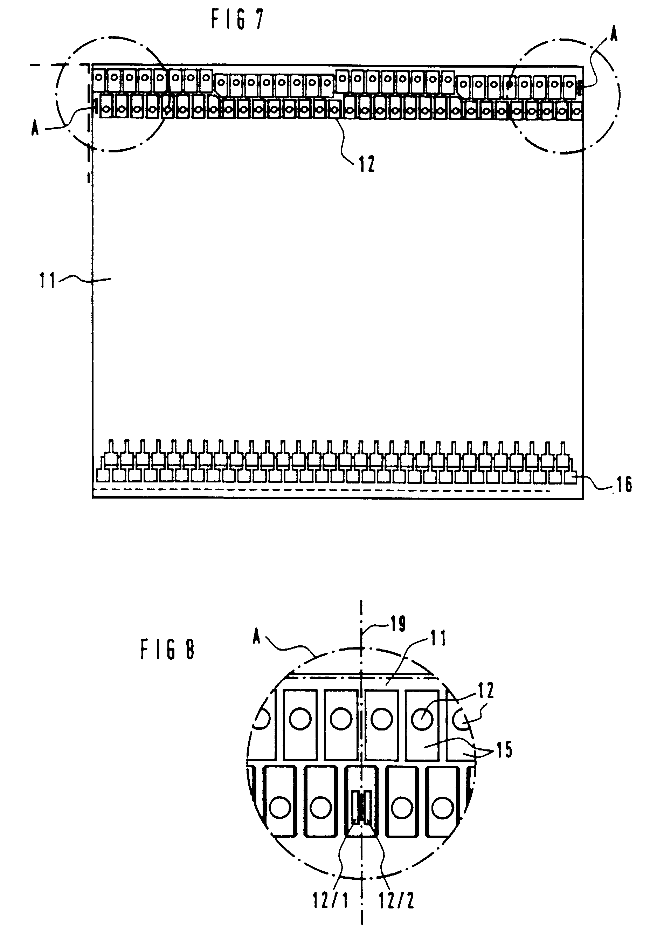

Hergestellt werden die Monolithen 11 in Dünnschicht-Strukturierungstechnik aus III-V Halbleitermaterial, einem Verfahren, wie es z.B. in der DE-C2-37 26 235 beschrieben ist. Hierzu werden die Strukturen der beliebig ausgeführten Ansteuerschaltung 13 für die LED's und die LED's 12 selbst auf einem Substrat aus III-V Halbleitermaterial vorzugsweise Gallium-Arsenid (GaAs) Material Schicht für Schicht aufgebaut. Die LED's 12 selbst sind mit einer Deckschicht 15 (Figur 8) mit darauf ausgebildeten Lichtaustrittsöffnungen 12 abgedeckt. Diese Lichtaustrittsöffnungen 12 definieren Lichtpunkte zur punktweisen Auf- oder Entladung der Fotoleitertrommel des elektrografischen Druckers und sie sind auf den Monolithen 11 in einem vorgegebenen Rastermaß entlang einer Zeile angeordnet. Üblicherweise erfolgt eine Fokussierung der Leuchtpunkte 12 durch eine hier nicht dargestellte Fokussiereinrichtung in Form z.B. einer Selfoc-Einrichtung.

Der Schichtaufbau kann für mehrere Monolithe 12 gleichzeitig auf einem Wafer erfolgen. Danach werden die Monolithe 11 entsprechend der gewünschten Größe aus dem Wafer geschnitten und in einer entsprechenden Prüfeinrichtung auf Funktion geprüft. Nach der Prüfung erfolgt der Einbau in den Zeichengenerator, z.B. mit Hilfe eines Bestückungsautomaten, wobei die einzelnen Monolithe 11 auf einer hochgenau bearbeiteten Oberfläche eines Metallträgers 10 mit Hilfe von Silberleitkleber geklebt und gegebenenfalls über ihre Anschlüsse 16 (Bond-Pads) mit Leitungszuführungen verbunden werden.

Zu den Ausführungsformen im einzelnen:

### Figur 1

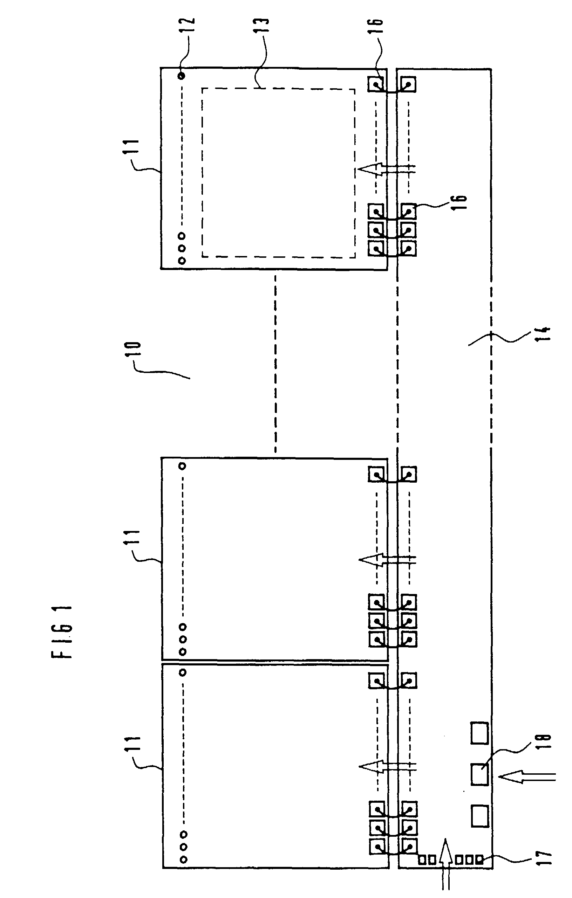

Bei der Ausführungsform des Zeichengenerators entsprechend der Figur 1 ist in den Mono-lithen 11 die Ansteuerschaltung 13 für die LED's 12 mitintegriert, wobei die LED's 12 in Form einer einzeiligen LED-Reihe angeordnet sind. Sämtliche Mono-lithen 11 oder Chips sind nebeneinander auf dem Träger 10 befestigt, so daß eine durchgehende LED-Zeile aus einzeln erregbaren LED's 12 gebildet wird. Die LED's 12 sind dabei im Bereich einer Vorderkante der Monolithen 11 angeordnet und werden über die im Monolithen 11 integrierte Ansteuerschaltung 13 angesteuert. Mit sämtlichen Monolithen 11 über Bond-Pads 16 verbunden ist eine separate BUS-Ansteueranordnung, die die Ansteuerschaltung 13 mit Ansteuerdaten versorgt. Die BUS-Schaltung 14 besteht bei dem dargestellten Ausführungsbeispiel aus einem separaten integrierten Schaltkreis, der über Daten-Pads 17 mit der Steuerung des Gerätes verbindbar ist. Weiterhin weist die BUS-Schaltung 14 Stromversorgungs-Pads 18 auf. Die Pfeile bezeichnen die Zuführrichtung der Daten in und aus dem BUS 14, sowie die Zuführrichtung des Stromes der Stromversorgung.

Durch diese Konfiguration wird erreicht, daß nur noch zwischen den Monolithen 11 und dem BUS 14 über die Bond-Pads 16 gebondet werden muß.

Stellt sich während des Betriebes ein Defekt in einem der Monolithen 11 des Zeichengenerators heraus oder treten Störungen im BUS 14 auf, so muß nur das entsprechende Bauelement des Zeichengenerators ausgetauscht werden. Dies ist infolge der reduzierten Anschlüsse leicht möglich.

### Figur 2

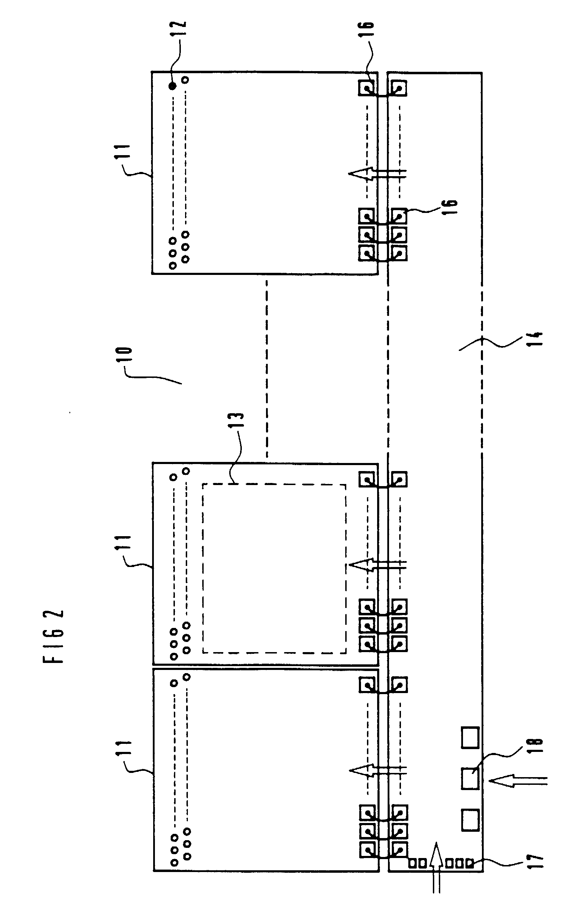

Eine wesentliche Verbesserung der Druckbilder ergibt sich, wenn entsprechend der Ausführungsform der Figur 2 die LED's 12 in zwei Reihen versetzt zueinander angeordnet sind, derart, daß beim Belichten des Fotoleiters eine Überlappung der Belichtungspunkte erfolgt. Durch die zweireihige Anordnung besteht die Möglichkeit, mit vergrößerten Leuchtfenstern 12 den Wirkungsgrad der LED-Arrays durch höhere Strahlungsleistung (pro Stromeinheit) zu steigern und außerdem den gewünschten Überlappungsgrad der Leuchtpunkte auf dem Fotoleiter einzustellen.

Üblicherweise werden derartige Monolithen mit zweireihigen LED-Leisten aus dem Wafer durch einen schrägen Schnitt getrennt. Ein derartiger schräger Schnitt läßt sich jedoch vermeiden, wenn entsprechend der Darstellung der Figur 8 ein in den Bereich einer Chip-Trennlinie 19 fallendes Leuchtfenster so ausgebildet wird, daß es zwei Teil-Lichtaustrittsöffnungen 12/1 und 12/2 aufweist, zwischen denen die Chiptrennlinie 19 verläuft. Die beiden Teil-Lichtaustrittsöffnungen 12/1 und 12/2 sind im zusammengesetzten Zustand des Zeichengenerators jeweils benachbarten Monolithen 11 zugeordnet und bilden so bei gemeinsamer Erregung einen gemeinsamen Leuchtpunkt. Die dazwischen verlaufende Trennlinie stört nicht, da für das Rastermaß allein der Schwerpunkt der am Leuchtpunkt beteiligten Lichtelemente maßgebend ist. Auch die andere Form der Teil-Lichtaustrittsöffnungen 12/1 und 12/2 wirkt sich nicht negativ auf die Auflösung aus, zumal die nachgeschaltete Selfoc-Einrichtung für eine entsprechende Fokussierung sorgt.

### Figur 3, Figur 4

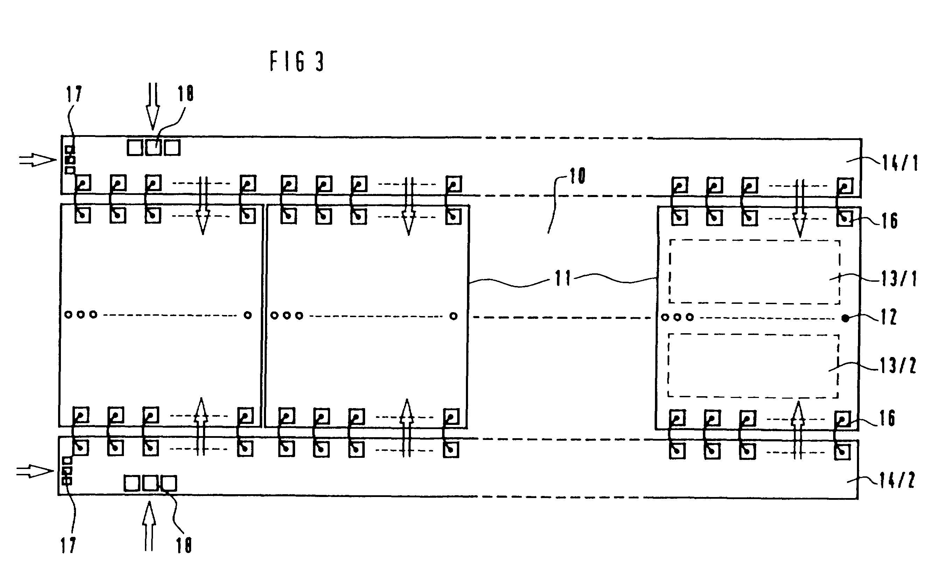

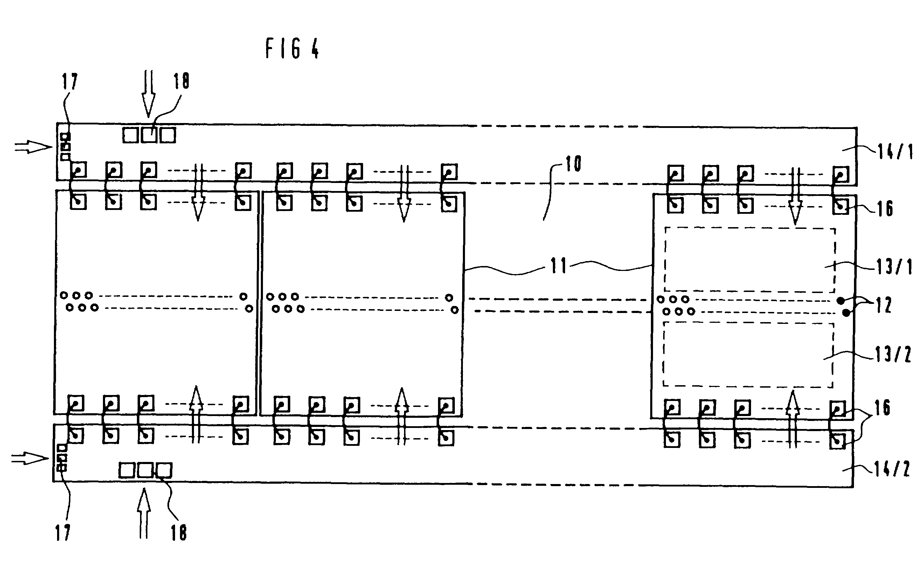

Wenn der Abstand der Leuchtfenster 12 voneinander bei immer höher werdender Auflösung sehr gering wird, so besteht die Möglichkeit, die LED-Reihe mittig auf dem Monolithen 11 anzuordnen und sowohl die Versorgungsströme als auch die BitDaten beidseitig zuzuführen. In den Ausführungsbeispielen entsprechend den Figuren 3 und 4 ist diese symmetrische Anordnung sowohl für eine LED-Reihe als auch für eine Zweireihenanordnung dargestellt. Die Monolithen 11 mit ihren zugehörigen integrierten Ansteuerschaltungen 13 werden dabei über zwei getrennte BUS-Schaltungen 14 mit Daten versorgt. Die Ansteuerschaltung 13 im Monolith kann dabei als getrennte Ansteuerschaltungen 13/1 und 13/2 ausgebildet sein, die jeweils Gruppen von LED's des Monolithen 11 ansteuern Zum Beispiel kann das erste, dritte, fünfte usw. LED der Reihe über die Ansteuerschaltung 13/1 angesteuert werden und das zweite, vierte, sechste usw. über die Ansteuerschaltung 13/2 oder aber es kann bei einer zweireihigen LED-Anordnung die Ansteuerschaltung 13/1 die eine Reihe und die Ansteuerschaltung 13/2 die andere Reihe der LED's ansteuern.

### Figur 5, Figur 6

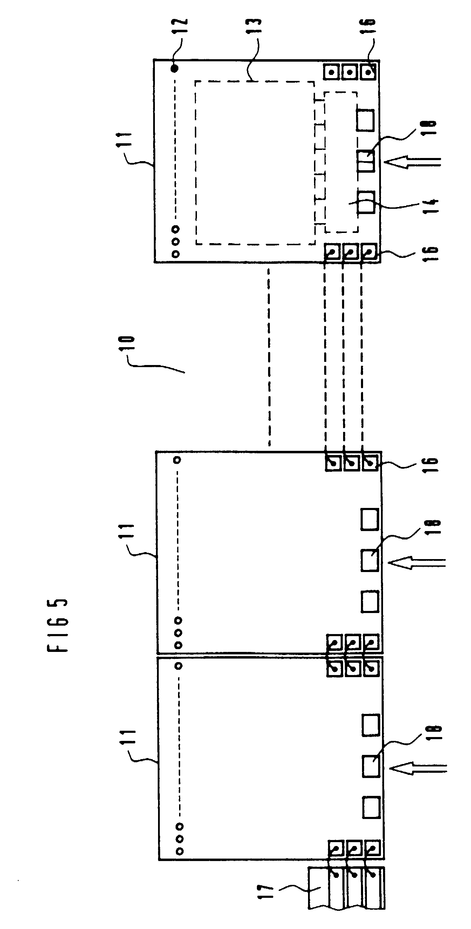

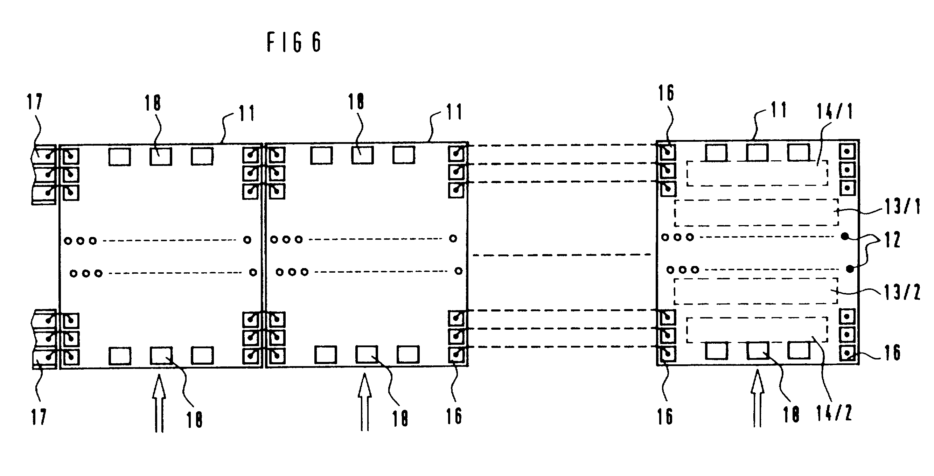

Eine Steigerung der Integration bedeutet es, wenn entsprechend den Ausführungsbeispielen der Figuren 5 und 6 die BUS-Schaltung 14 zusätzlich in die Monolithen 11 integriert wird. In diesem Fall werden die BOND-Pads 16 der Monolithen 11 zweckmäßigerweise so angeordnet, daß benachbarte Bond-Pads der Monolithen 11 einander gegenüberliegen. Bei einer derartigen Integration der BUS-Schaltung 14 in die Monolithen 11 sollten innerhalb der Monolithen zusätzliche Schieberegister integriert werden, die bei genügend hohen Taktfrequenzen die Bitdaten mit ihren Adressierungen von Monolith zu Monolith weitergeben. Bei einer mittig symmetrischen LED-Anordnung entsprechend der Figur 6 sind beidseitig der zweireihigen LED-Leiste BUS- und Ansteuerschaltung integriert angeordnet und zusätzlich Schieberegister ausgebildet, die beidseitig die integrierten Schaltungen jeweils für die obere und untere LED-Reihe aktivieren. Die Stromversorgungen über die Stromversorgungs-Pads 18 erfolgt ebenfalls beidseitig.

### Bezugszeichenliste

- 10: Träger, Aufnahmefläche für Chips
- 11: Monolith, Chip
- 12: LED, Lichtaustrittsöffnung
- 13: Ansteuerschaltung für die LED's
- 14: BUS-Schaltung
- 15: Deckschicht
- 16: Anschlußkontakte, Bond-Pads

- 17: Daten-Pads
- 18: Stromversorgungs-Pads
- 19: Chip-Trennlinie
- 12/1, 12/2: Teil-Lichtaustrittsöffnungen
- 13/1, 13/2: Ansteuerschaltungen bei symmetrischem Aufbau der Monolithe

## Patentansprüche

1. Optischer Zeichengenerator für einen elektrografischen Drucker mit einer Mehrzahl von auf einem Träger (10) angeordneten Monolithen (11), wobei jeder Monolith darin integrierte, einzeln ansteuerbare LED's (12) und eine dem Zeichengenerator zugeordnete Ansteuerschaltung (13) für die LED's (12) umfaßt, wobei die LED's eine Deckschicht (15) mit zugehöriger Lichtaustrittsöffnung (12) aufweisen, wobei jede Lichtaustrittsöffnung einem Lichtpunkt zugeordnet ist, und die Lichtaustrittsöffnungen (12) entsprechend einem vorgegebenen Raster einzeilig oder mehrzeilig versetzt zueinander angeordnet sind,
**dadurch gekennzeichnet,** daß auf benachbarten Mono-lithen (11) an den gegenüberliegenden Rändern jeweils eine Teil-Lichtaustrittsöffnung (12/1, 12/2) ausgebildet ist, so daß durch gemeinsame Ansteuerung dieser Teil-Lichtaustrittsöffnungen (12/1, 12/2) ein gemeinsamer Lichtpunkt gebildet wird, der den Bereich zwischen den benachbarten Monolithen (11) übergreift.

2. Optischer Zeichengenerator nach Anspruch 2, **dadurch gekennzeichnet,** daß die Monolithen (11) aus einer monolithisch integrierten Fotodioden-Ansteuerkombination bestehen, bei der in einem Monolith (11) sowohl die zugehörigen LED's (12) als auch die Ansteuerschaltung (13) für die LED's (12) integriert sind.

3. Optischer Zeichengenerator nach einem der Ansprüche 1 oder 2, **dadurch gekennzeichnet,** daß die LED's und die Ansteuerschaltung (13) aus dem gleichen Halbleitermaterial aufgebaut sind.

4. Optischer Zeichengenerator nach einem der Ansprüche 1 bis 3, **dadurch gekennzeichnet**, daß das Halbleitermaterial aus III-V Halbleitermaterial besteht und der oder die Monolithen (11) auf einem Trägersubstrat aus III-V Halbleitermaterial aufgebaut sind.

5. Optischer Zeichengenerator nach einem der Ansprüche 1 bis 4,
**gekennzeichnet** durch Gallium-Arsenid als Halbleitermaterial.

6. Optischer Zeichengenerator nach einem der Ansprüche 1 bis 5,
**gekennzeichnet** durch eine BUS-Ansteueranordnung (14) zur Zuführung von Ansteuerdaten zu der Ansteuerschaltung (13), die in den Monolithen (11) integriert angeordnet ist.

7. Optischer Zeichengenerator nach Anspruch 6,
**dadurch gekennzeichnet**, daß die Monolithen (11) auf dem Träger (10) nebeneinander angeordnet sind und Anschlußkontakte (16) für die BUS-Ansteueranordnung (14) aufweisen, derart, daß die Anschlußkontakte (16) der einzelnen Monolithe (11) einander gegenüberliegend angeordnet sind, wobei die BUS-Ansteueranordnungen benachbarter Monolithe über diese Anschlußkontakte (16) koppelbar sind.

8. Optischer Zeichengenerator nach einem der Ansprüche 1 bis 7,
**dadurch gekennzeichnet**, daß der oder die Monolithen hinsichtlich der Anordnung der Ansteuerschaltung (13) und/oder der BUS-Ansteueranordnung (14) symmetrisch bezogen auf eine oder mehrere mittig auf den Monolithen (11) angeordneten LED-Zeilen aufgebaut sind.

9. Optischer Zeichengenerator nach einem der Ansprüche 1 bis 8,
**dadurch gekennzeichnet**, daß die Monolithen mit dem Träger (10) über eine wärmeleitende Klebeverbindung verbunden sind.

10. Optischer Zeichengenerator nach Anspruch 9,
**dadurch gekennzeichnet**, daß die Klebeverbindung als Silberleitklebeverbindung ausgebildet ist.

## Claims

1. An optical character generator for an electrographic printer having a plurality of monolithic circuits (11) which are arranged on a carrier (10), each monolithic circuit comprising LEDs (12), which are integrated therein and can be driven individually, and a drive circuit (13), which is assigned to the character generator, for the LEDs (12), the LEDs having a covering layer (15) with an associated light outlet opening (12), each light outlet opening (12) being assigned to a light spot, and the light outlet openings (12) being arranged offset with respect to one another in one row or in a plurality of rows corresponding to a predetermined grid, characterized in that a partial light outlet opening (12/1, 12/2) is in each case constructed on the opposite edges of adjacent monolithic circuits (11), such that a common light spot is formed by jointly driving these partial light outlet openings (12/1, 12/2), which light spot extends over the area between the adjacent monolithic circuits (11).

2. The optical character generator as claimed in claim 1, characterized in that the monolithic circuits (11) comprise a monolithically integrated photodiode drive combination, in the case of which both the associated LEDs (12) and the drive circuit (13) for the LEDs (12) are integrated in a monolithic circuit (11).

3. The optical character generator as claimed in one of claims 1 and 2, characterized in that the LEDs and the drive circuit (13) are constructed from the same semiconductor material.

4. The optical character generator as claimed in one of claims 1 to 3, characterized in that the semiconductor material comprises III-V semiconductor material and the monolithic circuit or monolithic circuits (11) is or are constructed on a carrier substrate made of III-V semiconductor material.

5. The optical character generator as claimed in one of claims 1 to 4,
characterized by gallium arsenide as the semiconductor material.

6. The optical character generator as claimed in one of claims 1 to 5,
characterized by a BUS drive arrangement (14) for supplying drive data to the drive circuit (13), which is arranged in an integrated manner in the monolithic circuits (11).

7. The optical character generator as claimed in claim 6,
characterized in that the monolithic circuits (11) are arranged side by side on the carrier (10) and have connecting contacts (16) for the BUS drive arrangement (14) in such a manner that the connecting contacts (16) of the individual monolithic circuits (11) are arranged opposite one another, it being possible to couple the BUS drive arrangements of adjacent monolithic circuits via these connecting contacts (16).

8. The optical character generator as claimed in one of claims 1 to 7,
characterized in that, with respect to the arrangement of the drive circuit (13) and/or of the BUS drive arrangement (14), the monolithic circuit or the monolithic circuits is or are constructed symmetrically with respect to one or more LED rows which is or are arranged centrally on the monolithic circuits (11).

9. The optical character generator as claimed in one of claims 1 to 8,
characterized in that the monolithic circuits are connected to the carrier (10) via a thermally conductive bonded joint.

10. The optical character generator as claimed in claim 9,
characterized in that the bonded joint is designed as a silver conductive bonded joint.

## Revendications

1. Générateur optique de caractères pour une imprimante électrographique, comprenant une multiplicité de monolithes (11) agencés sur un support (10), chaque monolithe comprenant, intégrées en lui, des diodes électrolumisuscentes ou DEL (12) commandées individuellement et un circuit de commande (13) associé au générateur de caractères pour la commande des DEL (12), les DEL présentant chacune une couche de revêtement (15) munie d'une ouverture de sortie de lumière respective (12), chaque ouverture de sortie de lumière correspondant à un point lumineux, et les ouvertures de sortie de lumière (12) étant disposées avec décalage les unes par rapport aux autres sur une seule ligne ou sur plusieurs lignes, selon une matrice prédéterminée,
caractérisé en ce que, sur chacun de deux monolithes (11) adjacents, au niveau des bords opposés, est formée une ouverture partielle de sortie de lumière (12/1, 12/2), de sorte que, par commande commune de ces ouvertures partielles de sortie de lumière (12/1, 12/2), on forme un point lumineux commun qui chevauche la zone située entre les monolithes (11) adjacents.

2. Générateur optique de caractères selon la revendication 1, caractérisé en ce que les monolithes (11) sont composés d'une combinaison de commandes de photodiodes intégrée de façon monolithique, dans laquelle aussi bien les DEL respectives (12) que le circuit de commande (13) associé aux DEL (12) sont intégrés dans un monolithe (11).

3. Générateur optique de caractères selon une des revendications 1 et 2, caractérisé en ce que les DEL et le circuit de commande (13) sont formés à partir du même matériau semi-conducteur.

4. Générateur optique de caractères selon une des revendications 1 à 3, caractérisé en ce que le matériau semi-conducteur est constitué par un matériau semi-conducteur III-V, et le ou les monolithes (11) est ou sont formé(s) sur un substrat support fait d'un matériau semi-conducteur III-V.

5. Générateur optique de caractères selon une des revendications 1 à 4, caractérisé par l'utilisation d'arséniure de gallium comme matériau semi-conducteur.

6. Générateur optique de caractères selon une des revendications 1 à 5, caractérisé par un dispositif de commande à BUS (14) servant à acheminer des données de commande au circuit de commande (13) qui est agencé de façon intégrée dans les monolithes (11).

7. Générateur optiques de caractères selon la revendication 6, caractérisé en ce que les monolithes sont disposés les uns à côté des autres sur le support (10) et présentent des contacts de connexion (16) pour le dispositif de commande à BUS (14), avec un agencement tel que les contacts de connexion (16) des différents monolithes (11) sont disposés face à face, les dispositifs de commande à BUS des monolithes adjacents pouvant être couplés par l'intermédiaire de ces contacts de connexion (16).

8. Générateur optique de caractères selon une des revendications 1 à 7, caractérisé en ce que l'agencement du circuit de commande (13) et/ou du dispositif de commande à BUS (14), est tel que le ou les monolithes est ou sont de constitution symétrique par rapport à une ou plusieurs lignes de DEL disposée(s) en position centrale sur les monolithes (11).

9. Générateur optique de caractères selon une des revendications 1 à 8, caractérisé en ce que les monolithes sont assemblés au support (10) au moyen d'une liaison collée conductrice de la chaleur.

10. Générateur optique de caractères selon la revendication 9, caractérisé en ce que la liaison collée est constituée par une liaison collée conductrice à l'argent.
